# EUROPEAN PATENT APPLICATION

(11) **EP 4 513 555 A1**
(43) Date of publication of application: **26.02.2025**
(21) Application number: 24804404.2
(22) Date of filing: 08.05.2024
(51) Int. Cl.: H01L 23/498

(54) **PACKAGE STRUCTURE AND SEMICONDUCTOR STRUCTURE**

(30) Priority: 29.05.2023 CN 202310624794
(71) Applicant: CXMT Corporation, Hefei, Anhui 230601 (CN)
(72) Inventor: SHI, Hengrong, Hefei, Anhui 230601 (CN); SHI, Honglong, Hefei, Anhui 230601 (CN)
(74) Representative: Gulde & Partner
(86) International application number: PCT/CN2024/091744
(87) International publication number: WO 2024/244927

(57) **Abstract**

A package structure and a semiconductor structure are provided. A package base is included, and a signal pin array is disposed on the surface of the package base; and the signal pin array includes multiple clock pins configured to carry a clock signal and multiple command address pins configured to carry a command address signal, the multiple clock pins are arranged in a first direction, and each of the clock pins is adjacent to one of the command address pins in a second direction. The size of the package structure is small.

## Description

This application claims priority to Chinese Patent Application No. 202310624794.8, filed with the China National Intellectual Property Administration on May 29, 2023 and entitled "PACKAGE STRUCTURE AND SEMICONDUCTOR STRUCTURE", which is incorporated herein by reference in its entirety.

### TECHNICAL FIELD

Embodiments of the present disclosure relate to the field of semiconductor technologies, and in particular, to a package structure and a semiconductor structure.

### BACKGROUND

An important purpose of packaging a microelectronic device (e.g., a chip) is to connect the device to higher-level packaging of an electronic system. One aspect of packaging is to convert a signal from a relatively small feature (e.g., a bond pad or a rewiring bond pad) of a die to a larger and wider connection position of next higher-level packaging (e.g., a circuit board).

However, update cycles of various types of chips become shorter. Therefore, it is necessary to provide a package structure meeting a requirement of a next-generation memory chip.

### SUMMARY

According to a first aspect of the embodiments of the present disclosure, a package structure is provided and includes:
a package base, a signal pin array being disposed on the surface of the package base; the signal pin array including multiple clock pins configured to carry a clock signal and multiple command address pins configured to carry a command address signal, the multiple clock pins being arranged in a first direction, and each of the clock pins being adj acent to one of the command address pins in a second direction; the first direction being a column extension direction of the signal pin array, and the second direction being a row extension direction of the signal pin array.

In some embodiments, multiple chip select pins configured to carry a chip select signal are further included in the signal pin array; the multiple chip select pins are arranged in the first direction; and each chip select pin is adjacent to one command address pin in the second direction.

In some embodiments, the multiple chip select pins configured to carry the chip select signal and multiple data pins configured to carry a data signal are further included in the signal pin array; one of the chip select pins is further adjacent to one of the data pins in the first direction; and one of the clock pins is further adjacent to another one of the command address pins in the first direction.

In some embodiments, the multiple chip select pins configured to carry the chip select signal and the multiple data pins configured to carry the data signal are further included in the signal pin array; the signal pin array is sequentially divided into a first edge row, a data transmission region, a control transmission region, and a second edge row in the first direction; the multiple data pins are all located in the data transmission region, and any two of the data pins are not linearly adjacent to each other; the multiple command address pins, the multiple clock pins, and the multiple chip select pins are all located in the control transmission region; a maximum of three of the command address pins are allowed to be consecutively arranged in the first direction; and a maximum of two of the command address signals are allowed to be consecutively arranged in the second direction.

In some embodiments, the signal pin array is sequentially divided into a first longitudinal region, a central column, and a second longitudinal region in the second direction, the quantity of signal pins in the first longitudinal region is the same as the quantity of signal pins in the second longitudinal region, and a pin in the central column is removed. The multiple data pins are located in a non-edge column of the first longitudinal region and a non-edge column of the second longitudinal region, and the data pins in the first longitudinal region and the data pins in the second longitudinal region are symmetrical about the central column. The multiple command address pins are located in a portion of the first longitudinal region close to the central column and a portion of the second longitudinal region close to the central column, and the command address pins in the first longitudinal region and the command address pins in the second longitudinal region are symmetrical about the central column.

In some embodiments, the multiple chip select pins are located in the first longitudinal region, and the chip select pins are located on a side of the adjacent command address pins away from the central column; and multiple clock signal pins are located in the second longitudinal region and adjacent to the central column.

In some embodiments, the data transmission region is divided into a first transmission region and a second transmission region in the first direction, the total quantity of pins in the first transmission region is greater than the total quantity of pins in the first transmission region, and the quantity of the data pins in the first transmission region is the same as the quantity of the data pins in the second transmission region. Each of the data pins in the first transmission region is configured to transmit a high-order data signal, and each of the data pins in the second transmission region is configured to transmit a low-order data signal; or each of the data pins in the first transmission region is configured to transmit a low-order data signal, and each of the data pins in the second transmission region is configured to transmit a high-order data signal.

In some embodiments, two pairs of data strobe pins carrying a data strobe signal are further included in the signal pin array, the first pair of the data strobe pins is located in the first transmission region, the second pair of the data strobe pins is located in the second transmission region, and the data strobe pins are all adjacent to the central column; two pins of each pair of the data strobe pins are adjacent to each other in the first direction, and the first pair of the data strobe pins is not adjacent to the second pair of the data strobe pins in the first direction; and the first pin of each pair of the data strobe pins is linearly adjacent to at least one of the data pins, and the second pin of each pair of the data strobe pins is not linearly adjacent to any one of the data pins.

In some embodiments, two pairs of first auxiliary control pins are further distributed in the data transmission region, the first pair of the first auxiliary control pins and the first pair of the data strobe pins are symmetrical about the central column, and the second pair of the first auxiliary control pins and the second pair of the data strobe pins are symmetrical about the central column; and another pin in the data transmission region is a power pin or a ground pin.

In some embodiments, one pin of each pair of the first auxiliary control pins is configured to carry a mask control signal or a terminal data strobe signal, and the other pin of each pair of the first auxiliary control pins is configured to transmit a ground signal or serves as a reserved signal pin.

In some embodiments, multiple second auxiliary control pins, multiple third auxiliary control pins, multiple fourth auxiliary control pins, a fifth auxiliary control pin, and a sixth auxiliary control pin are further distributed in the control transmission region. The multiple second auxiliary control pins and the multiple chip select pins are symmetrical about the central column; the multiple third auxiliary control pins and the multiple fourth auxiliary control pins are symmetrical about the central column, one of the third auxiliary control pins, one of the chip select pins, and one of the command address pins are consecutively arranged in the second direction, and one of the command address pins, one of the second auxiliary control pins, and one of the fourth auxiliary control pins are consecutively arranged in the second direction; and the fifth auxiliary control pin and the sixth auxiliary control pin are symmetrical about the central column. The fifth auxiliary control pin and the third auxiliary control pins are located in the same column, and the fifth auxiliary control pin is not adjacent to the third auxiliary control pins; and the sixth auxiliary control pin and the fourth auxiliary control pins are located in the same column, and the sixth auxiliary control pin is not adjacent to the fourth auxiliary control pins; and another pin in the control transmission region is a power pin or a ground pin.

In some embodiments, a local data pin carrying a local data signal and a local data strobe pin carrying a local data strobe signal are distributed in the first edge row, the local data pin and the local strobe data pin are symmetrical about the central column, the local data pin is adjacent to one of the data pins in the first direction, and the local data strobe pin is adjacent to one of the data pins in the first direction; a seventh auxiliary control pin is further distributed in the first edge row, the seventh auxiliary control pin is adjacent to the central column, and the seventh auxiliary control pin is adjacent to the data pins in the first direction; and other pins in the first edge row and the second edge row are all power pins or ground pins.

In some embodiments, at least one of the second auxiliary control pins is configured to carry a test mode enable signal, and at least one of the second auxiliary control pins serves as a reserved signal pin; at least one of the third auxiliary control pins carries a mirror mode enable signal, and at least one of the third auxiliary control pins is configured to carry a check error signal; at least one of the fourth auxiliary control pins is configured to carry a first protocol signal, and at least one of the fourth auxiliary control pins is configured to carry a second protocol signal; the fifth auxiliary control pin is configured to carry a termination signal, and the sixth auxiliary control pin is configured to carry a reset signal; and the seventh auxiliary control pin is a calibration pin configured to carry an impedance calibration signal.

In some embodiments, the signal pin array has 14 rows, the first longitudinal region has 4 columns, and the second longitudinal region has 4 columns. Package forms of the pins of the signal pin array are ball grids, in the first direction, the distance between center points of adjacent two of the ball grids is a first value, in the first direction, the distance between center points of adjacent two of the ball grids is a second value, and the first value is less than the second value.

According to a second aspect, an embodiment of the present disclosure provides a semiconductor structure, including the package structure according to the first aspect and a chip, and a data bit width of the chip is 4 bits, 8 bits, or 16 bits.

The embodiments of the present disclosure provide the package structure and the semiconductor structure, which can be compatible with chips of different specifications, and have strong adaptability and a small overall area.

### BRIEF DESCRIPTION OF DRAWINGS

FIG. 1 is a schematic diagram of a package structure according to an embodiment of the present disclosure;
FIG. 2 is a schematic diagram of another package structure according to an embodiment of the present disclosure;
FIG. 3 is a schematic diagram 1 of a signal pin array according to an embodiment of the present disclosure;
FIG. 4 is a schematic diagram 2 of a signal pin array according to an embodiment of the present disclosure;
FIG. 5 is a schematic diagram 3 of a signal pin array according to an embodiment of the present disclosure;
FIG. 6 is a schematic diagram 4 of a signal pin array according to an embodiment of the present disclosure;
FIG. 7 is a schematic diagram of a signal pin array;
FIG. 8 is a schematic diagram of another signal pin array according to an embodiment of the present disclosure; and
FIG. 9 is a schematic structural diagram of a semiconductor structure according to an embodiment of the present disclosure.

### DESCRIPTION OF EMBODIMENTS

The technical solutions of the present disclosure are further described below in detail with reference to the accompanying drawings and the embodiments. Although example implementations of the present disclosure are shown in the accompanying drawings, it should be understood that the present disclosure may be implemented in various forms without being limited by the implementations described herein. Instead, these implementations are provided to develop a more thorough understanding of the present disclosure and to fully convey the scope of the present disclosure to a person skilled in the art.

In the following paragraphs, the present disclosure is described more specifically by way of example with reference to the accompanying drawings. The advantages and features of the present disclosure will be clearer from the following description and claims. It should be noted that the accompanying drawings are presented in a highly simplified form and are not to exact scale, and are merely intended to conveniently and clearly assist in describing the embodiments of the present disclosure.

It may be understood that meanings of "on", "over", and "above" in the present disclosure should be understood in the broadest sense, so that "on" means that it is "on" something with no intermediate feature or layer (that is, directly on something), and further includes the meaning that it is "on" something with an intermediate feature or layer.

In the embodiments of the present disclosure, the terms "first", "second", "third", and the like are intended to distinguish between similar objects but do not necessarily indicate a specific order or sequence.

In the embodiments of the present disclosure, the term "layer" refers to a material part including a region having a thickness. The layer may extend over the whole of a lower or upper structure, or may have a range smaller than the range of the lower or upper structure. In addition, the layer may be a region of a homogeneous or heterogeneous continuous structure whose thickness is less than the thickness of a continuous structure. For example, the layer may be located between the top surface and the bottom surface of the continuous structure, or the layer may be located between any horizontal surface pair at the top surface and the bottom surface of the continuous structure. The layer may extend horizontally, vertically, and/or along an inclined surface. Multiple sublayers may be included in the layer.

It should be noted that the technical solutions described in the embodiments of the present disclosure may be arbitrarily combined when there is no conflict.

Static random access memory (SRAM);
dynamic random access memory (DRAM);
synchronous dynamic random access memory (SDRAM);
double data rate SDRAM (DDR);
fifth generation DDR (DDR5).
sixth generation DDR (DDR6);
two-line bidirectional serial bus protocol (I3C); and
printed circuit board (PCB).

Before the embodiments of the present disclosure are described, three directions that may be configured to describe a three-dimensional structure of a plane in the following embodiments are first defined. In an example of a Cartesian coordinate system, the three directions may include an X-axis direction, a Y-axis direction, and a Z-axis direction (not involved in the embodiments of the present disclosure). A package structure may include a top surface located on the front and a bottom surface located on the back opposite to the front. When flatness of the top surface and the bottom surface is ignored, a direction intersecting with (e.g., perpendicular to) the top surface and the bottom surface of the package structure is defined as a third direction. In a direction of the top surface and the bottom surface (that is, a plane in which the package structure is located) of the package structure, two directions intersecting with each other are defined. For example, a column extension direction of a signal pin array may be defined as a first direction, a row extension direction of the signal pin array may be defined as a second direction, and a plane direction of the package structure may be determined based on the first direction and the second direction. In the embodiments of the present disclosure, the first direction and the second direction may be perpendicular to each other. In another embodiment, the first direction and the second direction may not be perpendicular to each other.

In addition, the term "linearly adjacent" utilized in combination with the signal pin array in this specification represents and includes pins directly above, directly below, directly on the left, and directly on the right of a given pin when the signal pin array is parallel to the plane of the drawing; the term "diagonal arrangement" utilized in combination with the signal pin array in this specification represents and includes pins on the upper right, the lower right, the upper left, and the lower left of a given pin when the signal pin array is parallel to the plane of the drawing; and the term "around the pin" utilized in combination with the signal pin array in this specification represents and includes pins directly above, directly below, directly on the left, and directly on the right, on the upper right, the lower right, the upper left, and the lower left of a given pin when the signal pin array is parallel to the plane of the drawing. The term "a pin A is adjacent to a pin B in a first direction" utilized in combination with the signal pin array in this specification includes only that when the signal pin array is parallel to the plane of the drawing, the pin A is adjacent to the pin B and the pin A is directly above or directly below the pin B. The term "a pin A is adjacent to a pin B in a second direction" utilized in combination with the signal pin array in this specification includes only that when the signal pin array is parallel to the plane of the drawing, the pin A is adjacent to the pin B and the pin A is directly on the left or directly on the right of the pin B.

In particular, the illustrations presented in the present disclosure are not meant to be actual views of any specific microelectronic device package, signal pin array, or components thereof, but are only idealized representations for describing illustrative embodiments. Therefore, the illustrations are not necessarily drawn to scale.

DDR6 chips with a 4-bit data bit width (X4), an 8-bit data bit width (X8), and a 16-bit data bit width (X16) are utilized in subsequent descriptions of the embodiments of the present disclosure. Therefore, Table 1 is provided to describe related signals and the quantities of signals utilized in packaging of the foregoing chips.

**Table 1**

| | | DDR6 X16 | DDR6 X8 | DDR6 X4 |
|---|---|---|---|---|
| Low-order data related | Low-order data signal dql[7:0] | 8 | 8 | 4 |
| | Low-order data strobe signal dqsl_t/dqsl_c | 2 | 2 | 2 |
| | Terminal data strobe signal tdqs_t (low-order mask inversion control signal dml) | 1 | 1 | 1 |
| High-order data related | High-order data signal dqu[7:0] | 8 | 0 | 0 |
| | High-order data strobe | 2 | 0 | 0 |
| | signal dqsu_t/dqsu_c | | | |
| | Terminal data strobe signal tdqs_c (high-order mask inversion control signal dmu) | 1 | 1 | 1 |
| Locally related | Local data signal lbdq/Local data strobe signal lbdqs | 2 | 2 | 2 |
| Command address related | Command address signal ca[13:0] | 14 | 14 | 14 |
| | On-chip termination signal ca_odt | 1 | 1 | 1 |
| | Clock signal ck_t/ck_c | 2 | 2 | 2 |
| Power support related | Power signal vddq | 15 | 15 | 15 |
| | Power signal vdd | 16 | 16 | 16 |
| | Ground signal vss | 27 | 27 | 27 |
| | Power signal vpp | 2 | 2 | 2 |
| Others | Test mode enable signal ten | 1 | 1 | 1 |
| | Chip select signal cs_n[1:0] | 2 | 2 | 2 |
| | I3C protocol-related signal (msda and msdl) | 2 | 2 | 2 |
| | Mirror mode enable signal mir | 1 | 1 | 1 |
| | Impedance calibration | 1 | 1 | 1 |
| | signal zq | | | |
| | Check error indication signal alert_n | 1 | 1 | 1 |
| | Reset signal reset | 1 | 1 | 1 |
| | Reserved signal rfu | 2 | 2 | 2 |
| Total | | 112 | - | - |

In particular, the X8 chip requires the terminal data strobe signals tdqs_c and tdqs_t, and the X4 chip and the X16 chip do not require the terminal data strobe signals tdqs_c and tdqs_t, but require the mask inversion control signals dmu_n and dml_n. In particular, for the same design specification, the terminal data strobe signal may utilize the same signal pin with the mask inversion control signal, that is, tdqs_c and dmu_n utilize the same pin, and tdqs_t and the dml_n utilize the same pin.

The following describes the embodiments of the present disclosure in detail with reference to the accompanying drawings.

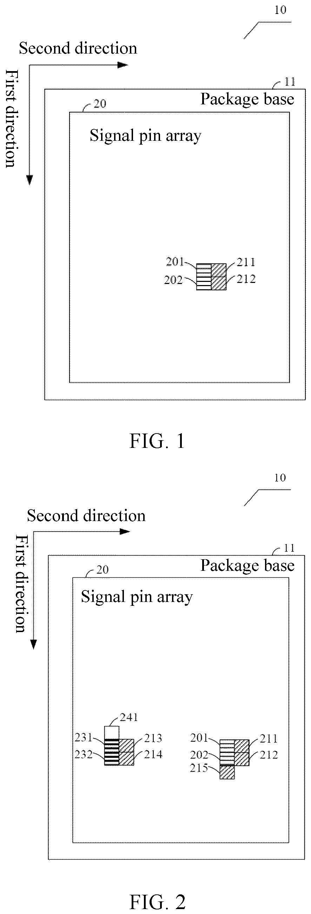

In an embodiment of the present disclosure, referring to FIG. 1, FIG. 1 is a schematic diagram of a package structure 10 according to an embodiment of the present disclosure. As shown in FIG. 1, the package structure 10 includes a package base 11, and a signal pin array 20 (a ball grid array) is disposed on the surface of the package base 11.

It should be noted that, the package structure 10 provided in this embodiment of the present disclosure is applicable to at least DDR5 or DDR6, and may simultaneously support DDR5 or DDR6 chips whose data bit widths are 4 bits, 8 bits, and 16 bits. Specifically, the DDR chip includes a device substrate, and the device substrate includes a semiconductor material and a bond pad coupled to an active surface of the device substrate. The package base is secured to the device substrate, the package base 11 is configured to route signals to/from the bond pad, and the signal pin array 20 is supported on and electrically connected to the package base 11. In particular, the distribution position of the signal pin array 20 on the package base 11 is merely an example and constitutes no limitation. Actually, the surface of the package base 11 is not necessarily a completely regular rectangle, and the signal pin array 20 may be distributed in any region on the surface of the package base 11.

In the following description, a first direction is a column extension direction of the signal pin array 20, and a second direction is a row extension direction of the signal pin array 20.

As shown in FIG. 1, multiple clock pins (201, 202) configured to carry a clock signal and multiple command address pins (only some are shown in FIG. 1, namely, 211 and 212) configured to carry a command address signal are included in the signal pin array 20. The multiple clock pins (201, 202) are arranged in the first direction, and each clock pin is adjacent to one command address pin in the second direction. For example, the clock pin 201 is adjacent to the command address pin 211 in the second direction, and the clock pin 202 is adjacent to the command address pin 212 in the second direction.

That is, the multiple clock pins are located in the same column and adjacent to each other, and one clock pin and one command address pin are located in the same row and adjacent to each other.

It should be noted that two clock pins are shown in FIG. 1, but there may be more or fewer clock pins in an actual scenario. FIG. 1 is taken as an example. The clock pin 201 is specifically configured to transmit the clock signal ck_t in Table 1, and the clock pin 202 is specifically configured to transmit the clock signal ck_c in Table 1. The clock signal ck_t and the clock signal ck_c are a pair of differential signals.

In this way, in this embodiment of the present disclosure, the clock pin is allowed to be adjacent to the command address pin in the second direction, so that the size of the signal pin array 20 can be reduced, and the area of the base can be reduced. In addition, the clock pin is adjacent to the command address pin in the second direction, to better match latency of a clock and that of an address. Therefore, the overall transmission path is shorter, the signal integrity is improved, and the competitive capability of the overall product is improved.

In some embodiments, as shown in FIG. 2, multiple chip select pins (231, 232) configured to carry a chip select signal are further included in the signal pin array 20, and the multiple chip select pins (231, 232) are arranged in the first direction. Each chip select pin is adjacent to one command address pin in the second direction, for example, the chip select pin 231 is adjacent to the command address pin 213 in the second direction.

That is, the multiple chip select pins are located in the same column and adjacent to each other, and one chip select pin and one command address pin are located in the same row and adjacent to each other.

It should be noted that two chip select pins are shown in FIG. 2, but there may be more or fewer chip select pins in an actual scenario. FIG. 2 is taken as an example. The chip select pin 231 is specifically configured to transmit the chip select signal cs_n[0] in Table 1, and the chip select pin 232 is specifically configured to transmit the chip select signal cs_n[1] in Table 1. At most one of the chip select signal cs_n[0] and the chip select signal cs_n[1] is valid.

In this way, in this embodiment of the present disclosure, the chip select pin is allowed to be adjacent to the command address pin in the second direction, so that the quantity of rows occupied by address signals in the signal pin array 20 can be decreased, the space can be further saved, and a time sequence between clock and address signals can be better matched.

In some embodiments, as shown in FIG. 2, multiple data pins (only one is shown in FIG. 2, namely, 241) carrying a data signal are further included in the signal pin array 20. One chip select pin 232 is further adjacent to one data pin 241 in the first direction. One clock pin 202 is further adjacent to another command address pin 215 in the first direction.

In this way, in this embodiment of the present disclosure, the chip select pin is allowed to be adjacent to the command address pin in the second direction, and the chip select pin is allowed to be adjacent to the data pin in the first direction. In addition, the clock pin is allowed to be adjacent to the command address pin in both the first direction and the second direction, so that the signal distribution is centralized under the premise that the signal quality meets a requirement.

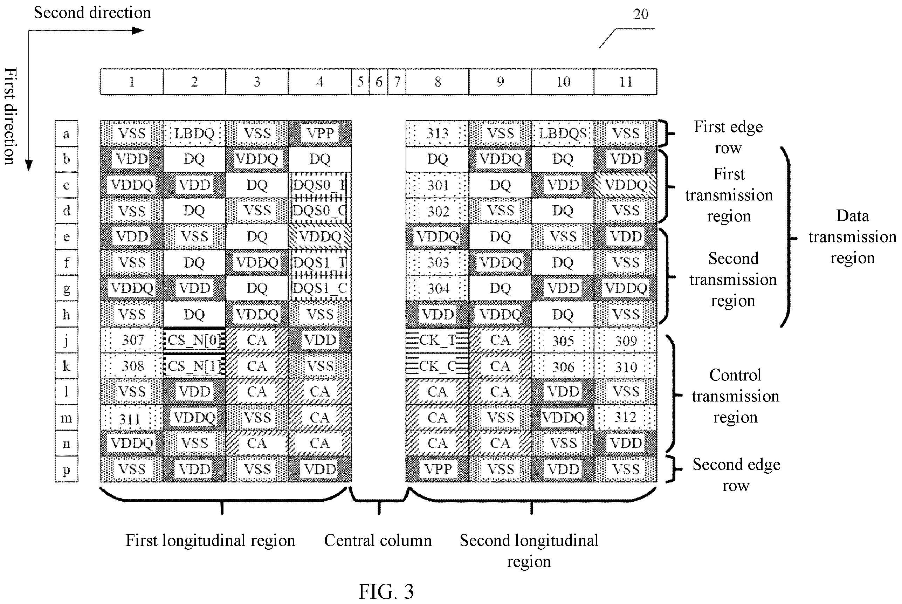

For ease of description, referring to FIG. 3, FIG. 3 shows an arrangement illustration of a signal pin array 20 in a specific application scenario of a DDR6 chip. In FIG. 3, the signal pin array 20 has 14 rows (row numbers are sequentially a-p)×11 columns (column numbers are sequentially 1-11), including 16 data pins DQ, 14 command address pins CA, 2 clock pins (CK_T and CK_C), and 2 chip select pins (CS_N[0] and CS_N[1]). It should be understood that FIG. 3 shows merely a specific implementation of the present disclosure, and the size of the signal pin array 20, the quantities of signals of different types, and a detailed arrangement of the signals may be adaptively adjusted without departing from the following text description.

In some embodiments, as shown in FIG. 3, the signal pin array 20 is sequentially divided into a first edge row, a data transmission region, a control transmission region, and a second edge row in the first direction. Multiple data pins DQ are all located in the data transmission region, and any two data pins DQ are not linearly adjacent to each other; and multiple command address pins CA, multiple clock pins (CK_T and CK_C), and multiple chip select pins (CS_N[0] and CS_N[1]) are all located in the control transmission region.

It should be noted that for one data pin DQ, another data pin DQ is not allowed to be distributed directly above, directly below, directly on the left, and directly on the right of the data pin DQ. However, another data pin DQ is allowed to be distributed on the upper left, on the lower left, on the upper right, and on the lower right of the data pin DQ. That is, two data pins DQ may be in diagonal arrangement, but may not be linearly adjacent to each other, to alleviate a problem of signal distortion caused by magnetic field superposition.

It should be noted that, the signal pin array 20 in FIG. 3 includes 16 data pins DQ in total, and can support chips with 4-bit, 8-bit, and 16-bit data bit widths. In short, if the package structure 10 is applied to a chip with a 4-bit data bit width (X4), only four data pins are enabled, and the remaining 12 data pins are not connected; if the package structure 10 is applied to a chip with an 8-bit data bit width (X8), only eight data pins are enabled, and the remaining eight data pins are not connected; and if the package structure 10 is applied to a chip with a 16-bit data bit width (X16), all the data pins are enabled.

In some embodiments, as shown in FIG. 3, the signal pin array 20 is sequentially divided into a first longitudinal region, a central column, and a second longitudinal region in the second direction, and the quantity of signal pins in the first longitudinal region is the same as the quantity of signal pins in the second longitudinal region.

It should be noted that a pin in the central column is removed. In other words, after the signal pin array 20 is completed, each pin in the central column needs to be removed, to facilitate wiring on a PCB. There are three central columns in FIG. 3, but this does not constitute a related limitation. There may be more or fewer central columns. In particular, in FIG. 3, the length of each of the central columns (that is, the fifth/sixth/seventh column) is relatively short in the second direction, but this is only for saving page space. Actually, all the columns of the signal pin array 20 basically have the same length in the second direction.

Referring to FIG. 3, multiple data pins DQ are located in a non-edge column of the first longitudinal region and a non-edge column of the second longitudinal region, and the data pins DQ in the first longitudinal region and the data pins DQ in the second longitudinal region are symmetrical about the central column. In this way, the data pins DQ in the first longitudinal region and the second longitudinal region are mutually mirrored, so that a via hole can be shared when a double-sided placement design is performed on the PCB. In addition, the data pins DQ are disposed in neither the first column nor the last column (namely, the edge columns), thereby shortening the length of the data pins DQ in the second direction.

For example, as shown in FIG. 3, even-numbered data pins DQ are distributed in the second, third, and fourth columns, and odd-numbered data pins DQ are distributed in the eighth, ninth, and tenth columns. Alternatively, even-numbered data pins DQ are distributed in the eighth, ninth, and tenth columns, and odd-numbered data pins DQ are distributed in the second, third, and fourth columns.

Referring to FIG. 3, multiple command address pins CA are located in a portion of the first longitudinal region close to the central column and a portion of the second longitudinal region close to the central column, and the command address pins CA in the first longitudinal region and the command address pins CA in the second longitudinal region are symmetrical about the central column. That is, the command address pins CA in the first longitudinal region and the second longitudinal region are mutually mirrored, so that a via hole can be shared when a double-sided placement design is performed on the PCB. In addition, the command address pins CA are distributed in neither the first two columns nor the last two columns, thereby shortening the length of the command address pins CA in the second direction.

For example, as shown in FIG. 3, even-numbered command address pins CA are distributed in the third and fourth columns, and odd-numbered command address pins CA are distributed in the ninth and tenth columns. Alternatively, even-numbered command address pins CA are distributed in the ninth and tenth columns, and odd-numbered command address pins CA are distributed in the third and fourth columns.

It should be noted that a maximum of three command address pins are allowed to be consecutively arranged in the first direction; and a maximum of two command address signals are allowed to be consecutively arranged in the second direction.

In this way, the data pins DQ are not linearly arranged adjacent to each other in both the first direction and the second direction, to avoid the intensity and degree of overlap in the magnetic field generated by carried data signals, so that the signal has higher quality and fidelity. In addition, the command address pins CA are more compactly distributed, thereby reducing the area occupied by the overall signal pin array.

In some embodiments, the multiple chip select pins (CS_N[0] and CS_N[1]) are located in the first longitudinal region, and the chip select pins are located on a side of the adjacent command address pins CA away from the central column; and the multiple clock signal pins are located in the second longitudinal region and are adjacent to the central column.

In this way, the multiple clock signal pins (CK_T and CK_C) are adjacent to the central column, and can be located in the fourth column or the eighth column, and rows of the multiple clock signal pins are adjacent to each other, thereby facilitating wiring on the PCB or the base.

In some embodiments, referring to FIG. 3, the data transmission region is divided into a first transmission region and a second transmission region in the first direction, the total quantity of pins in the first transmission region is greater than the total quantity of pins in the first transmission region, and the quantity of the data pins DQ in the first transmission region is the same as the quantity of the data pins DQ in the second transmission region.

In a first possible case, the data pin DQ in the first transmission region is configured to transmit a high-order data signal (namely, dqu[7:0] in Table 1), and the data pin DQ in the second transmission region is configured to transmit a low-order data signal (namely, dql[7:0] in Table 1). In this case, for DDR6 with a 4-bit data bit width, only four data pins in the second transmission region are enabled. For DDR6 with an 8-bit data bit width, only eight data pins are enabled, and only eight data pins in the second transmission region are enabled. For DDR6 with a 16-bit data bit width, all the data pins are enabled.

In a second possible case, the data pin DQ in the first transmission region is configured to transmit a low-order data signal (namely, dql[7:0] in Table 1), and the data pin DQ in the second transmission region is configured to transmit a high-order data signal (namely, dqu[7:0] in Table 1). In this case, for DDR6 with the 4-bit data bit width, only four data pins in the first transmission region are enabled. For DDR6 with an 8-bit data bit width, only eight data pins are enabled, and only eight data pins in the first transmission region are enabled. For DDR6 with a 16-bit data bit width, all the data pins are enabled.

In this way, in this embodiment of the present disclosure, a transmission region of the high-order data signal and a transmission region of the low-order data signal are independent of each other, so that the layout is more proper.

In some embodiments, as shown in FIG. 3, two pairs of data strobe pins carrying a data strobe signal are further included in the signal pin array 20. A first pair of data strobe pins are identified as DQS0_T and DQS0_C, and transmit a pair of differential signals. A second pair of data strobe pins are identified as DQS1_T and DQS1_C, and also transmit a pair of differential signals. That is, one pair of data strobe pins are configured to transmit dqsl_t and dqsl_c in Table 1, and the other pair of data strobe pins are configured to transmit dqsu_t and dqsu_c in Table 1.

The first pair of data strobe pins (DQS0_T, DQS0_C) is located in the first transmission region, the second pair of data strobe pins (DQS1_T, DQS1_C) is located in the second transmission region, and all the data strobe pins (DQS0_T, DQS0_C, DQS1_T, DQS1_C) are adjacent to the central column. Two pins of each pair of data strobe pins are adjacent to each other in the first direction, that is, the data strobe pin DQS0_T and the data strobe pin DQS0_C are adjacent to each other in the first direction, and the data strobe pin DQS1_T and the data strobe pin DQS1_C are adjacent to each other in the first direction. The first pair of data strobe pins are not adjacent to the second pair of data strobe pins in the first direction. Herein, "not adjacent" means that there is at least one pin between the "first pair of data strobe pins" and the "second pair of data strobe pins". For example, in FIG. 3, there is one power pin VDDQ between the data strobe pins DQS0_C and DQS1_T.

In this way, each pair of data strobe pins can be located in the fourth column or the eighth column, and rows of two pins in each pair of data strobe pins are adjacent to each other, thereby facilitating wiring on the PCB or the base.

It should be noted that a first pin of each pair of data strobe pins is linearly adjacent to at least one data pin DQ, that is, one data pin DQ is respectively distributed directly above and directly on the left of the data strobe pin DQS0_T, and one data pin DQ is distributed directly on the left of the data strobe pin DQS1_C. In addition, a second pin of each pair of data strobe pins is not linearly adjacent to any data pin DQ. Herein, "not linearly adjacent" means that the data pin DQ is not allowed to be distributed directly above, directly below, directly on the left, and directly on the right of "the other pin of each pair of data strobe pins".

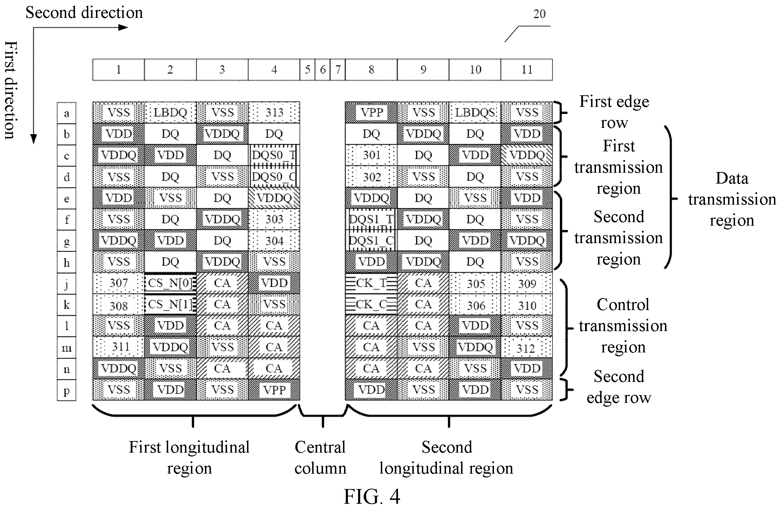

It should be further noted that in FIG. 3, all the data strobe pins are in the same column. In some other embodiments, referring to FIG. 4, the first pair of data strobe pins (DQS0_T, DQS0_C) is located in a column of the first longitudinal region close to the central column, and the second pair of data strobe pins (DQS0_T, DQS0_C) is located in a column of the second longitudinal region close to the central column. In still some other embodiments, the first pair of data strobe pins (DQS0_T, DQS0_C) is located in a column of the second longitudinal region close to the central column, and the second pair of data strobe pins (DQS0_T, DQS0_C) is located in a column of the first longitudinal region close to the central column.

In some embodiments, referring to FIG. 3 or FIG. 4, two pairs of first auxiliary control pins (301-304) are further distributed in the data transmission region. A first pair of first auxiliary control pins (301, 302) and the first pair of data strobe pins (DQS0_T, DQS0_C) are symmetrical about the central column. A second pair of first auxiliary control pins (301, 302) and the second pair of data strobe pins (DQS1_T, DQS1_C) are symmetrical about the central column. Other pins in the data transmission region are all power pins or ground pins VSS.

It should be noted that based on different functions and/or voltage values, the power pins are identified as VDD, VDDQ, and VPP. In particular, at least one ground pin and one power pin are distributed around each data pin DQ. Herein, "around the data pin DQ" includes adjacent pins directly above, directly below, directly on the left, and directly on the right, on the upper left, the lower left, the upper right, and the lower right of the data pin DQ. This implements an isolation function, and further facilitates generation of a data signal.

In some embodiments, as shown in FIG. 3 or FIG. 4, multiple second auxiliary control pins (305, 306), multiple third auxiliary control pins (307, 308), multiple fourth auxiliary control pins (309, 310), a fifth auxiliary control pin 311, and a sixth auxiliary control pin 312 are further distributed in the control transmission region.

First, the multiple second auxiliary control pins (305, 306) and the multiple chip select pins (CS_N[0], CS_N[1]) are symmetrical about the central column.

Second, the multiple third auxiliary control pins (307, 308) and the multiple fourth auxiliary control pins (309, 310) are symmetrical about the central column, one third auxiliary control pin, one chip select pin, and one command address pin CA are consecutively arranged in the second direction, and one command address pin CA, one second auxiliary control pin, and one fourth auxiliary control pin are consecutively arranged in the second direction. As shown in FIG. 3, the third auxiliary control pin 307, the chip select pin CS_N[0], and one command address pin CA are consecutively arranged in the second direction, and the third auxiliary control pin 308, the chip select pin CS_N[1], and one command address pin CA are consecutively arranged in the second direction. In addition, one command address pin CA, the second auxiliary control pin 305, and the fourth auxiliary control pin 309 are consecutively arranged in the second direction, and one command address pin CA, the second auxiliary control pin 306, and the fourth auxiliary control pin 310 are consecutively arranged in the second direction.

Finally, the fifth auxiliary control pin 311 and the sixth auxiliary control pin 312 are symmetrical about the central column, the fifth auxiliary control pin 311 and the third auxiliary control pins (307 and 308) are in the same column, and the fifth auxiliary control pin 311 is not adjacent to the third auxiliary control pins (307 and 308). The sixth auxiliary control pin 312 and the fourth auxiliary control pins (309 and 310) are located in the same column, and the sixth auxiliary control pin 312 is not adjacent to the fourth auxiliary control pins (309 and 310).

Other pins in the control transmission region are power pins or ground pins, that is, the other pins in the control transmission region are either power pins or ground pins.

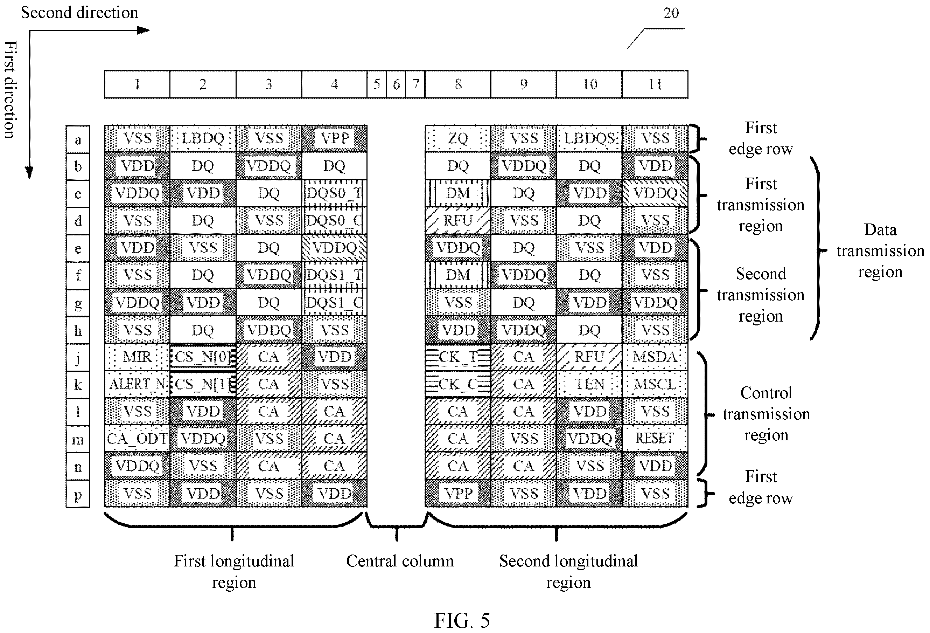

In some embodiments, referring to FIG. 5, a local data pin LBDQ carrying a local data signal lbdq and a local data strobe pin LBDQS carrying a local data strobe signal lbdqs are further distributed in the first edge row, the local data pin LBDQ and the local strobe data pin LBDQS are symmetrical about the central column, the local data pin LBDQ is adjacent to one data pin DQ in the first direction, and the local data strobe pin LBDQS is adjacent to one data pin DQ in the first direction.

A seventh auxiliary control pin 313 is further distributed in the first edge row, the seventh auxiliary control pin 313 is adjacent to the central column, and the seventh auxiliary control pin 313 is adjacent to the data pins DQ in the first direction. Other pins in the first edge row and the second edge row are all power pins or ground pins. Specifically, one power pin VPP overlaps another power pin VPP after rotating by 180 degrees along the center of the signal array.

It should be noted that in FIG. 5, the seventh auxiliary control pin 313 and the local data strobe pin LBDQS are located on the same side of the central column. In another embodiment, the seventh auxiliary control pin 313 and the local data pin LBDQ may be located on the same side of the central column. In this case, the position of the power pin VPP needs to be adjusted correspondingly.

For the 13 auxiliary control pins mentioned above, the 13 auxiliary control pins are relatively flexibly configured to transmit the following signals: mask control signals (dml, dmu) or terminal data strobe signals (tdqs_t, tdqs_c), a test mode enable signal ten (configured to control a chip to enter/not to enter a test mode), a reserved signal rfu (which can be customized by each manufacturer for utilizing), a mirror mode enable signal mir (configured to control a chip to enter/not to enter a mirror mode), a check error signal alert_n (configured to prompt that an error is detected in a cyclic redundancy check operation), a first protocol signal msda (an I3C related signal), a second protocol signal mscl (an I3C related signal), a termination signal ca_odt, a reset signal reset, and an impedance calibration signal zq.

It should be noted that the foregoing signals can be transmitted through any auxiliary control pin relatively flexibly, which mainly depends on a structure of an internal circuit and a wiring requirement. The following provides only an illustration and constitutes no specific limitation.

In this way, transmission of all the signals in Table 1 can be supported by the signal pin array 20, to be compatible with the X4, X8, and X16 chips.

In a specific embodiment, referring to FIG. 5, one pin DM of each pair of first auxiliary control pins is configured to carry the mask control signals (dml, dmu) or the terminal data strobe signals (tdqs_tdqs_c), and the other pin (VSS, RFU) of each pair of first auxiliary control pins is configured to transmit the ground signal vss or serves as a reserved signal pin. At least one second auxiliary control pin TEN is configured to carry the test mode enable signal ten, and at least one second auxiliary control pin RFU serves as a reserved signal pin. At least one third auxiliary control pin MIR carries the mirror mode enable signal mir, and at least one third auxiliary control pin ALERT_n is configured to carry the check error signal alert_n. At least one fourth auxiliary control pin MSDA is configured to carry the first protocol signal msda, and at least one fourth auxiliary control pin MSCL is configured to carry the second protocol signal mscl. The fifth auxiliary control pin CA_ODT is configured to carry the termination signal ca_odt, the sixth auxiliary control pin Reset is configured to carry the reset signal reset, and the seventh auxiliary control pin ZQ is configured to carry the impedance calibration signal zq.

In this way, some signals not sensitive to the length can be preferentially transmitted by an auxiliary control signal in an edge row or an edge column, and the layout is proper.

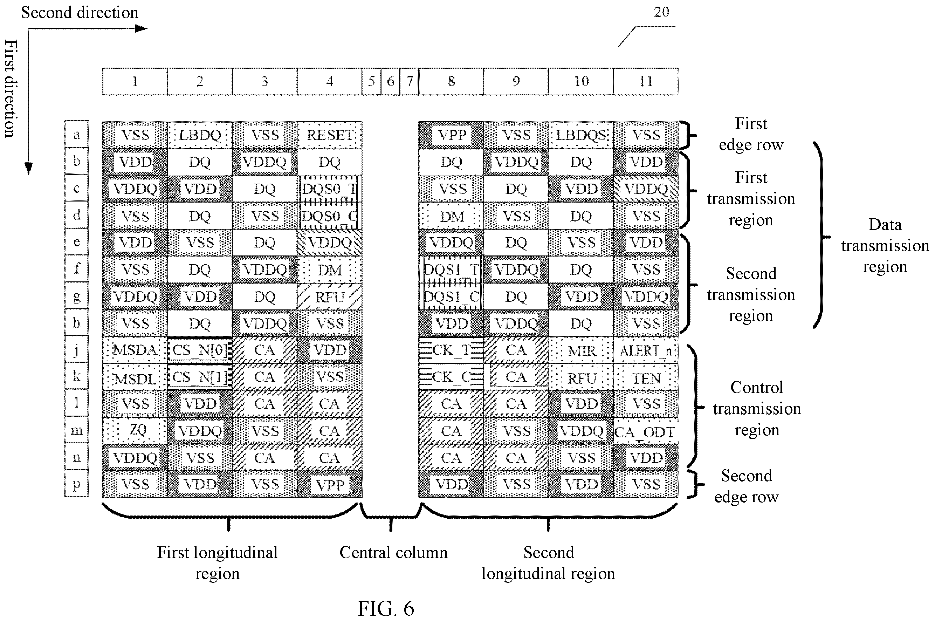

In another embodiment, as shown in FIG. 6, one pin DM of each pair of first auxiliary control pins is configured to carry the mask control signals (dml, dmu) or the terminal data strobe signals (tdqs_tdqs_c), and the other pin (VSS, RFU) of each pair of first auxiliary control pins is configured to transmit the ground signal or serves as a reserved signal pin. At least one second auxiliary control pin TEN carries the mirror mode enable signal MIR, and at least one second auxiliary control pin RFU serves as a reserved signal pin. At least one third auxiliary control pin MSDA is configured to carry the first protocol signal msda, and at least one third auxiliary control pin MSCL is configured to carry the second protocol signal mscl. At least one fourth auxiliary control pin ALERT_n is configured to carry the check error signal alert_n, and at least one fourth auxiliary control pin TEN is configured to carry the test mode enable signal ten. The fifth auxiliary control pin ZQ is configured to carry the impedance calibration signal zq, the sixth auxiliary control pin CA_ODT is configured to carry the termination signal ca_odt, and the seventh auxiliary control pin RESET is configured to carry the reset signal reset.

In addition, in this embodiment of the present disclosure, the ground pins VSS and the power pins (VDD/VDDQ) need to be arranged in a staggered manner and evenly distributed. In particular, the ground pins VSS are not adjacent to each other in the first direction, and the power pins (VDD/VDDQ) are not adjacent to each other in the first direction.

In some embodiments, the signal pin array 20 has 14 rows, the first longitudinal region has 4 columns, and the second longitudinal region has 4 columns. Package forms of the pins of the signal pin array 20 are ball grids, in the first direction, the distance between center points of adjacent two of the ball grids is a first value, in the first direction, the distance between center points of adjacent two of the ball grids is a second value, and the first value is less than the second value.

As shown in FIG. 3 to FIG. 6, the central column has three columns. In this case, the size of the signal pin array 20 is 14 rows × 11 columns, that is, the quantity of pins of the signal pin array 20 in the first direction is greater, and the quantity of pins of the signal pin array 20 in the second direction is less. Therefore, the distance between the center points of the two adjacent ball grids in the first direction can be reduced, thereby reducing the size of the signal pin array 20 as a whole.

In a specific embodiment, the first value is 750 microns and the second value is 800 microns, so that the overall size of the signal pin array 20 is 10 millimeters × 11 millimeters, and a total of 14×8=112 pins are provided.

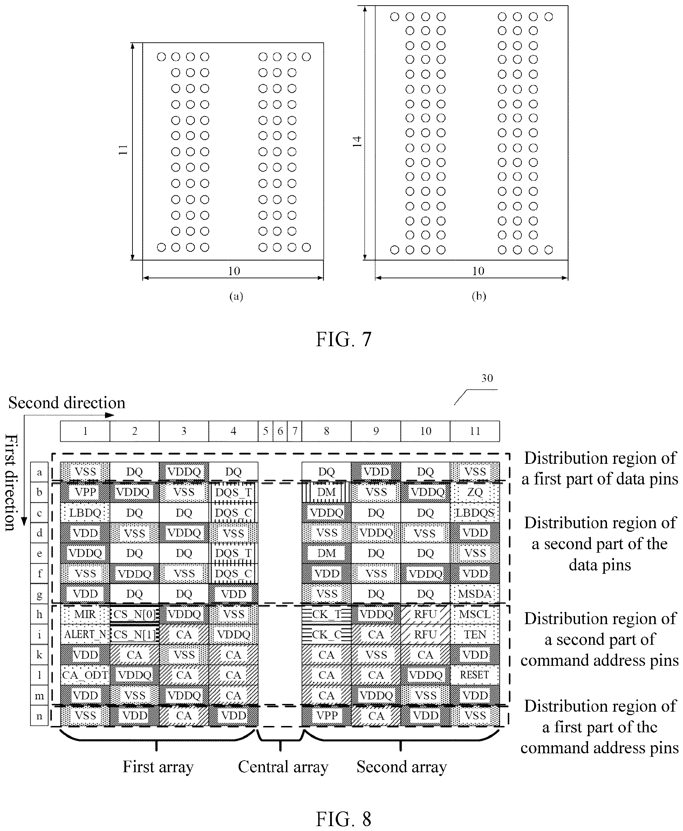

Referring to (a) in FIG. 7, (a) in FIG. 7 is a schematic diagram of a package structure of a chip with a 4-bit/8-bit data bit width. Referring to (b) in FIG. 7, (b) in FIG. 7 is a schematic diagram of a package structure of a chip with a 16-bit data bit width. The quantity of signal pins of the X4/X8 chip is different from the quantity of signal pins of the X16 chip. In this case, as shown in (a) in FIG. 7, for the X4/X8 chip, the chip has a total of 13×6 signal pins, at the four corners of the chip, there are four pins without signal connections (only for supporting), and the overall size is 10 millimeters × 11 millimeters. As shown in (b) in FIG. 7, for the X16 chip, the chip has a total of 17×6 signal pins, at the four corners of the chip, there are four pins without signal connections (only for supporting), and the overall size is 10 millimeters × 14 millimeters. That is, in comparison with the X4/X8 chip, the size of the X16 chip is larger, which requires a larger base area, and further makes X4/X8/X16 incompatible with a dual-inline-memory-module (DIMM) of the same specification.

It can be learned from the foregoing that, by utilizing the package structure 10 provided in the present disclosure, X4, X8, and X16 can share a base, and the size of the base can be close to the size in (a) in FIG. 7, so that more chip units can be cut out from one substrate, to reduce costs. In addition, a design period can be reduced, and it is unnecessary to design different bases for chips with different bit widths any longer. In addition, it is found by test that in comparison with (a) in FIG. 7, the signal pin array 20 provided in the present disclosure has a longer solder joint life, a relatively small plastic strain, and a longer fatigue life.

In another embodiment of the present disclosure, a signal pin array 30 is disposed on the surface of the package base 11. Referring to FIG. 8, FIG. 8 shows a schematic structural diagram of a signal pin array 30 according to an embodiment of the present disclosure. As shown in FIG. 8, the signal pin array 30 includes multiple data pins DQ, and the data pin DQ is configured to transmit a data signal. In a second direction, a maximum of two data pins DQ are allowed to be arranged adjacent to each other.

It should be noted that, in the first direction, a maximum of one data pin DQ is allowed to be arranged adjacent to each other, and the data pins DQ are distributed in a maximum of one row of two adjacent rows. In other words, there is a maximum of one data pin DQ around (directly above, directly below, directly on the left, and directly on the right, on the upper left, the upper right, the lower left, and the lower right of) each data pin DQ, so that a signal distortion problem is alleviated on the premise that transmission quality is ensured.

In particular, the signal pin array 30 provided in the present disclosure can also support X4, X8, and X16 chips.

In some embodiments, referring to FIG. 8, a first part of the data pins DQ are located in an edge row of the signal pin array, and any data pin DQ of the first part is not adjacent to another data pin DQ. A second part of the data pins DQ are located in a non-edge row and a non-edge column of the signal pin array 30, and every two data pins DQ of the second part are adjacent to each other in the second direction. In the first direction, there is a row of pins between data pins DQ of different rows.

In some embodiments, referring to FIG. 8, multiple command address pins CA are further included in the signal pin array 30, and the command address pin CA is configured to transmit a command address signal. A first part of the command address pins CA are located on an edge row of the signal pin array 30, and any command address pin CA of the first part is not adj acent to another command address pin CA. A second part of the command address pins CA are located in a non-edge row and a non-edge column of the signal pin array 30, a maximum of two command address pins CA of the second part are allowed to be consecutively arranged in the second direction, and a maximum of three command address pins CA of the second part are allowed to be consecutively arranged in the first direction. The first direction is a column extension direction of the signal pin array 30.

In this way, in the signal pin array 30, the data pin DQ is allowed to be located in the edge row, two data pins DQ are allowed to be consecutively arranged and adjacent to each other, and the command address pin CA is allowed to be located in the edge row, so that the area of the signal pin array can be reduced, and chip costs can be reduced.

In some embodiments, referring to FIG. 8, the signal pin array 30 has N rows in total, the first part of the data pins DQ are located in the first row, the second part of the data pins DQ are located in the 2nd to the Ath rows, the second part of the command address pins CA are located in the Bth to the (N-1)th rows, and the first part of the command address pins CA are located in the Nth row, where A, B, and N are all positive integers, A is less than B, and B is less than N-1.

In particular, FIG. 8 is only shown by utilizing N=13, A=7, and B=9 as an example.

In some embodiments, referring to FIG. 8, data pins DQ located in the 1st to the (C-1)th rows are configured to transmit a high-order data signal; and data pins DQ located in the (C+1)th to the Ath rows are configured to transmit a low-order data signal, where C=(A+1)/2. Alternatively, data pins DQ located in the 1st to the Cth rows are configured to transmit a low-order data signal; and data pins DQ located in the (C+1)th to the Ath rows are configured to transmit a high-order data signal. A pin located in the Cth row is a ground pin or a power pin, the ground pin is configured to transmit a ground signal, and the power pin is configured to transmit a power signal.

In some embodiments, referring to FIG. 8, in the second direction, the signal pin array 30 is divided into a first array, a central array, and a second array. The first array, the central array, and the second array are distributed in the second direction. The quantity of pins in the first array is the same as the quantity of pins in the second array, and all pins in the central array are removed.

A data pin DQ located in the first array and a data pin DQ located in the second array are symmetrical about the central array, and a command address pin CA located in the first array and a command address pin CAlocated in the second array are symmetrical about the central array.

In some embodiments, referring to FIG. 8, four data strobe pins (DQS_T, DQS_C) are further included in the signal pin array 30, and the data strobe pin is configured to transmit a data strobe signal. In the second direction, each data strobe pin is adjacent to the central array, and some of the data strobe pins are adjacent to the data pin DQ.

In the first direction, one data pin DQ, the first data strobe pin, the second data strobe pin, one ground pin or power pin, the third data strobe pin, and the fourth data strobe pin are consecutively arranged and adjacent to each other in the first direction.

In some embodiments, referring to FIG. 8, two first auxiliary control pins DM are further included in the signal pin array 30, and the first auxiliary control pin is configured to transmit a mask inversion control signal or transmit a terminal data strobe signal. One first auxiliary control pin and one data strobe pin are symmetrical about the central array.

In some embodiments, one local data strobe pin LBDQS, one local data pin LBDQ, and a seventh auxiliary control pin ZQ are further included in the signal pin array 30.

The local data strobe pin LBDQS is located in an edge column, and the local data strobe pin LBDQS is adjacent to one data pin DQ in the second direction.

The local data strobe pin LBDQS and the local data pin LBDQ are symmetrical about the central array.

The seventh auxiliary control pin ZQ is adjacent to the local data strobe pin LBDQS in the first direction.

The local data pin LBDQ is configured to transmit a local data signal, the local data strobe pin LBDQS is configured to transmit a local data strobe signal, and the seventh auxiliary control pin ZQ is configured to transmit an impedance calibration signal zq.

In some embodiments, referring to FIG. 8, two chip select pins (CS_N[0], CS_N[1]) adjacent to each other in the first direction are further included in the signal pin array 30, and the chip select pin is configured to transmit a chip select signal. The first chip select pin is adjacent to one data pin DQ in the first direction. The second chip select pin is adjacent to one command address pin CA in the second direction, and is adjacent to another command address pin CA in the first direction.

In some embodiments, two clock pins (CK_C, CK_T) adjacent to each other in the first direction are further included in the signal pin array 30, and the clock pin is configured to transmit a clock signal. The first clock pin is not adjacent to any command address pin CA. The second clock pin is adjacent to one command address pin CA in the second direction, and is adjacent to another command address pin CA in the first direction.

In some embodiments, referring to FIG. 8, the two chip select pins are located in the first array and are adjacent to an edge column of the signal pin array 30. The two clock pins are located in the second array and adjacent to the central array. The first chip select pin and the first clock pin are in the same row, and the second chip select pin and the second clock pin are in the same row.

In some embodiments, referring to FIG. 8, two third auxiliary control pins (MIR, ALERT_n) are further included in the signal pin array 30, and the two third auxiliary control pins are both located in an edge column of the signal pin array 30. The 1st third auxiliary control pin MIR is adjacent to the first chip select pin in the second direction. The 2nd third auxiliary control pin ALERT_n is adjacent to the second chip select pin in the second direction.

The 1st third auxiliary control pin MIR is configured to transmit at least a mirror mode enable signal, and the 2nd third auxiliary control pin ALERT_n is configured to transmit a check error indication signal.

In some embodiments, referring to FIG. 8, two reserved pins RFU, one second auxiliary control pin TEN, and two fourth auxiliary control pins (MSCL, MSDA) are further included in the signal pin array 30. The second auxiliary control pin TEN is configured to transmit a test mode enable signal, and the fourth auxiliary control pin is configured to transmit a protocol control signal.

The two reserved pins and the two chip select pins are symmetrical about the central array. The 2nd fourth auxiliary control pin MSCL and one third auxiliary control pin MIR are symmetrical about the central array, the second auxiliary control pin TEN and the other third auxiliary control pin ALERT_n are symmetrical about the central array, and the 1st fourth auxiliary control pin MSDA, the 2nd fourth auxiliary control pin MSCL, and the second auxiliary control pin TEN are consecutively arranged in the first direction.

In some embodiments, referring to FIG. 8, a fifth auxiliary control pin CA_ODT and a sixth auxiliary control pin RESET are further included in the signal pin array 30, and the fifth auxiliary control pin CA_ODT and the sixth auxiliary control pin RESET are located in edge columns of the signal pin array 30. The fifth auxiliary control pin CA_ODT and the sixth auxiliary control pin RESET are symmetrical about the central array. Pins to which the fifth auxiliary control pin CA_ODT is linearly adjacent are all ground pins and/or power pins, pins to which the sixth auxiliary control pin is linearly adjacent are all ground pins and/or power pins, the fifth auxiliary control pin CA_ODT and at least one command address pin CA are in the same row, and the sixth auxiliary control pin RESET and at least one command address pin CA are in the same row. The fifth auxiliary control pin CA_ODT is configured to transmit a termination signal, and the sixth auxiliary control pin RESET is configured to transmit a reset signal.

It should be noted that the signals transmitted by the foregoing auxiliary control pins are only an example, and do not constitute corresponding limitations. To be specific, for the foregoing mentioned auxiliary control pins, the auxiliary control pins are relatively flexibly configured to transmit the following signals: mask control signals (dml, dmu) or terminal data strobe signals (tdqs_t, tdqs_c), a test mode enable signal ten (configured to control a chip to enter/not to enter a test mode), a mirror mode enable signal mir (configured to control a chip to enter/not to enter a mirror mode), a check error signal alert_n (configured to prompt that an error is detected in a cyclic redundancy check operation), a first protocol signal msda (an I3C related signal), a second protocol signal mscl (an I3C related signal), a termination signal ca_odt, a reset signal reset, and an impedance calibration signal zq. In addition, the position of the reserved pin may alternatively be replaced with the position of the auxiliary control pin.

In some embodiments, referring to FIG. 8, the signal pin array 30 has 13 rows, the first array has 4 columns, the second array has 4 columns, and a total of 104 signal pins are provided, where A=7 and B=9.

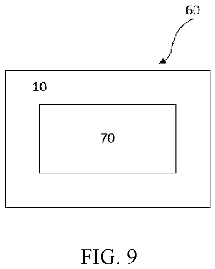

In still another embodiment of the present disclosure, referring to FIG. 9, FIG. 9 is a schematic structural diagram of composition of a semiconductor structure 60 according to an embodiment of the present disclosure. As shown in FIG. 9, the semiconductor structure 60 includes at least the foregoing package structure 10 and a chip 70, and a data bit width of the chip 70 is 4 bits, 8 bits, or 16 bits.

Herein, the chip 70 may be disposed on the package structure 10, and the chip 70 may be electrically connected to the signal pin array on the package base. Therefore, various signals related to the chip are output/input through the package structure 10.

In conclusion, the package structure 10 provided in the embodiments of the present disclosure may be compatible with chips with the X4, X8, and X16 specifications, so that chips with different bit widths can share the same base. In addition, the size of the base is smaller to control costs, and the overall performance is better.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A package structure (10), comprising a package base (11), a signal pin array (20) being disposed on a surface of the package base;
the signal pin array comprising a plurality of clock pins (201, 202) configured to carry a clock signal and a plurality of command address pins (211, 212) configured to carry a command address signal, the plurality of clock pins being arranged in a first direction, and each of the clock pins being adjacent to one of the command address pins in a second direction;
the first direction being a column extension direction of the signal pin array, and the second direction being a row extension direction of the signal pin array.

2. The package structure according to claim 1, wherein the signal pin array further comprises a plurality of chip select pins configured to carry a chip select signal; and
the plurality of chip select pins are arranged in the first direction; and each of the chip select pins is adjacent to one of the command address pins in the second direction.

3. The package structure according to claim 1 or 2, wherein the signal pin array further comprises the plurality of chip select pins configured to carry the chip select signal and a plurality of data pins configured to carry a data signal;
one of the chip select pins is further adjacent to one of the data pins in the first direction; and
one of the clock pins is further adjacent to another one of the command address pins in the first direction.

4. The package structure according to any one of claims 1 to 3, wherein the signal pin array further comprises the plurality of chip select pins configured to carry the chip select signal and the plurality of data pins configured to carry the data signal;
the signal pin array is sequentially divided into a first edge row, a data transmission region, a control transmission region, and a second edge row in the first direction;
the plurality of data pins are all located in the data transmission region, and any two of the data pins are not linearly adjacent to each other; and
the plurality of command address pins, the plurality of clock pins, and the plurality of chip select pins are all located in the control transmission region; a maximum of three of the command address pins are allowed to be consecutively arranged in the first direction; and a maximum of two of the command address signals are allowed to be consecutively arranged in the second direction.

5. The package structure according to any one of claims 1 to 4, wherein the signal pin array is sequentially divided into a first longitudinal region, a central column, and a second longitudinal region in the second direction, a quantity of signal pins in the first longitudinal region is the same as a quantity of signal pins in the second longitudinal region, and a pin in the central column is removed.

6. The package structure according to claim 5, wherein the plurality of data pins are located in a non-edge column of the first longitudinal region and a non-edge column of the second longitudinal region, and the data pins in the first longitudinal region and the data pins in the second longitudinal region are symmetrical about the central column.

7. The package structure according to claim 5 or 6, wherein the plurality of command address pins are located in a portion of the first longitudinal region close to the central column and a portion of the second longitudinal region close to the central column, and the command address pins in the first longitudinal region and the command address pins in the second longitudinal region are symmetrical about the central column.

8. The package structure according to claim 5, wherein
the plurality of chip select pins are located in the first longitudinal region, and the chip select pins are located on a side of the adjacent command address pins away from the central column; and
the plurality of clock signal pins are located in the second longitudinal region and adjacent to the central column.

9. The package structure according to any one of claims 5 to 8, wherein the data transmission region is divided into a first transmission region and a second transmission region in the first direction, a total quantity of pins in the second transmission region is greater than a total quantity of pins in the first transmission region, and a quantity of the data pins in the first transmission region is the same as a quantity of the data pins in the second transmission region.

10. The package structure according to claim 9, wherein each of the data pins in the first transmission region is configured to transmit a high-order data signal, and each of the data pins in the second transmission region is configured to transmit a low-order data signal; or each of the data pins in the first transmission region is configured to transmit a low-order data signal, and each of the data pins in the second transmission region is configured to transmit a high-order data signal.

11. The package structure according to claim 9, wherein the signal pin array further comprises two pairs of data strobe pins carrying a data strobe signal, a first pair of the data strobe pins is located in the first transmission region, a second pair of the data strobe pins is located in the second transmission region, and the data strobe pins are all adjacent to the central column;
two pins of each pair of the data strobe pins are adjacent to each other in the first direction, and the first pair of the data strobe pins is not adjacent to the second pair of the data strobe pins in the first direction; and
a first pin of each pair of the data strobe pins is linearly adjacent to at least one of the data pins, and a second pin of each pair of the data strobe pins is not linearly adjacent to any one of the data pins.

12. The package structure according to any one of claims 8 to 11, wherein
two pairs of first auxiliary control pins are further distributed in the data transmission region, a first pair of the first auxiliary control pins and the first pair of the data strobe pins are symmetrical about the central column, and a second pair of the first auxiliary control pins and the second pair of the data strobe pins are symmetrical about the central column; and
another pin in the data transmission region is a power pin or a ground pin.

13. The package structure according to claim 12, wherein
one pin of each pair of the first auxiliary control pins is configured to carry a mask control signal or a terminal data strobe signal, and the other pin of each pair of the first auxiliary control pins is configured to transmit a ground signal or serves as a reserved signal pin.

14. The package structure according to any one of claims 5 to 13, wherein a plurality of second auxiliary control pins, a plurality of third auxiliary control pins, a plurality of fourth auxiliary control pins, a fifth auxiliary control pin, and a sixth auxiliary control pin are further distributed in the control transmission region;
the plurality of second auxiliary control pins and the plurality of chip select pins are symmetrical about the central column; and
the plurality of third auxiliary control pins and the plurality of fourth auxiliary control pins are symmetrical about the central column, one of the third auxiliary control pins, one of the chip select pins, and one of the command address pins are consecutively arranged in the second direction, and one of the command address pins, one of the second auxiliary control pins, and one of the fourth auxiliary control pins are consecutively arranged in the second direction.

15. The package structure according to claim 14, wherein the fifth auxiliary control pin and the sixth auxiliary control pin are further distributed in the control transmission region;
the fifth auxiliary control pin and the sixth auxiliary control pin are symmetrical about the central column, the fifth auxiliary control pin and the third auxiliary control pins are located in a same column, and the fifth auxiliary control pin is not adjacent to the third auxiliary control pins; and the sixth auxiliary control pin and the fourth auxiliary control pins are located in a same column, and the sixth auxiliary control pin is not adjacent to the fourth auxiliary control pins; and
another pin in the control transmission region is a power pin or a ground pin.

16. The package structure according to claim 14, wherein
a local data pin carrying a local data signal and a local data strobe pin carrying a local data strobe signal are distributed in the first edge row, the local data pin and the local strobe data pin are symmetrical about the central column, the local data pin is adjacent to one of the data pins in the first direction, and the local data strobe pin is adjacent to one of the data pins in the first direction;
a seventh auxiliary control pin is further distributed in the first edge row, the seventh auxiliary control pin is adjacent to the central column, and the seventh auxiliary control pin is adjacent to the data pins in the first direction; and
other pins in the first edge row and the second edge row are all power pins or ground pins.

17. The package structure according to claim 15, wherein
at least one of the second auxiliary control pins is configured to carry a test mode enable signal, and at least one of the second auxiliary control pins serves as a reserved signal pin;
at least one of the third auxiliary control pins carries a mirror mode enable signal, and at least one of the third auxiliary control pins is configured to carry a check error signal;
at least one of the fourth auxiliary control pins is configured to carry a first protocol signal, and at least one of the fourth auxiliary control pins is configured to carry a second protocol signal;
the fifth auxiliary control pin is configured to carry a termination signal, and the sixth auxiliary control pin is configured to carry a reset signal; and
the seventh auxiliary control pin is a calibration pin configured to carry an impedance calibration signal.

18. The package structure according to any one of claims 5 to 17, wherein
the signal pin array has 14 rows, the first longitudinal region has 4 columns, and the second longitudinal region has 4 columns.

19. The package structure according to any one of claims 1 to 18, wherein
package forms of the pins of the signal pin array are ball grids, in the first direction, a distance between center points of adjacent two of the ball grids is a first value, in the first direction, a distance between center points of adjacent two of the ball grids is a second value, and the first value is less than the second value.

20. A semiconductor structure, comprising the package structure according to any one of claims 1 to 19 and a chip, a data bit width of the chip being 4 bits, 8 bits, or 16 bits.
